# EUROPÄISCHE PATENTSCHRIFT

(11) **EP 2 625 701 B1**
(45) Veröffentlichungstag und Bekanntmachung des Hinweises auf die Patenterteilung: **10.02.2016**
(21) Anmeldenummer: 11781459.0
(22) Anmeldetag: 07.10.2011
(51) Int. Cl.: H01F 38/30, H01R 4/46, H05K 5/02, H05K 13/04

(54) **VORRICHTUNG ZUR LÖSBAREN BEFESTIGUNG EINES STROMLEITERS AN EINEM STROMWANDLERGEHÄUSE**
APPARATUS FOR DETACHABLE ATTACHMENT OF AN ELECTRICAL CONDUCTOR TO A CURRENT TRANSFORMER HOUSING
DISPOSITIF DE FIXATION LIBÉRABLE D'UN CONDUCTEUR À UN BOÎTIER DE TRANSFORMATEUR DE COURANT

(30) Priorität: 07.10.2010 DE 202010008746 U; 07.10.2010 DE 102010038040
(43) Veröffentlichungstag der Anmeldung: 14.08.2013
(73) Patentinhaber: Phoenix Contact GmbH & Co. KG, 32825 Blomberg (DE)
(72) Erfinder: LEIFER, Christoph, 33014 Bad Driburg (DE); THÖRNER, Carsten, 49324 Melle (DE); DAT-MINH, Trinh, 32683 Barntrup (DE)
(74) Vertreter: Michalski Hüttermann & Partner Patentanwälte mbB
(86) Internationale Anmeldenummer: PCT/EP2011/067610
(87) Internationale Veröffentlichungsnummer: WO 2012/045884

(56) Entgegenhaltungen:
- DE-A1- 19 733 852
- DE-C1- 19 833 150
- FR-A5- 2 130 753

## Beschreibung

Die Erfindung betrifft eine Vorrichtung zur lösbaren Befestigung eines Stromleiters an einem Stromwandlergehäuse, mit dem Stromwandlergehäuse, einem durch das Stromwandlergehäuse hindurchgeführten Halteelement und einem durch das Halteelement hindurchgeführten Befestigungselement.

Aus dem Stand der Technik ist bekannt, einen Stromleiter durch eine an einem Stromwandlergehäuse vorgesehene Öffnung zu führen, wobei die Befestigung des Stromleiters an dem Stromwandlergehäuse üblicherweise über zwei Schrauben oder Gewindestifte erfolgt, welche in zwei an dem Stromwandlergehäuse angeordneten Halteelementen geführt sind. Zur Befestigung werden die Schrauben bzw. die Gewindestifte innerhalb der Halteelemente durch eine rein rotatorische Bewegung in Richtung des Stromleiters gedreht bis sie mit ihrer Querschnittsfläche auf der Oberfläche des Stromleiters aufliegen. Durch ein weiteres Drehen der Schrauben bzw. der Gewindestifte erfolgt die Fixierung des Stromleiters in dem Stromwandlergehäuse.

Entsprechend ist aus der DE 197 33 852 A1 ein Schienenstromwandler mit einer metallenen Lasche als Stromschienenklemme bekannt. Die Stromschienenklemme umfasst je einen Schraubbolzen an ihrem Anfang und Ende für die Arretierung auf der stromführenden Primärschiene. Dabei ist die Verbindung zwischen Stromwandler und Stromschienenklemme formschlüssig derart, dass die Stromschienenklemme mit dem Stromwandler eine unverlierbare Einheit bildet. Durch Herausschrauben eines Bolzens kann die Stromschienenklemme von dem Stromwandler getrennt werden.

Nachteilig hierbei ist, dass die Gewindestifte bzw. die Schrauben einen relativ langen Weg zur Befestigung an dem Stromleiter zurücklegen müssen, wobei dies ausschließlich durch eine rein rotatorische Bewegung erfolgt, was sehr kraftaufwändig und zeitintensiv ist, insbesondere bei einer größeren Anzahl zu fixierender Stromwandlergehäuse an einem Stromleiter.

Der Erfindung liegt daher die Aufgabe zugrunde, eine Vorrichtung zur Befestigung eines Stromleiters an einem Stromwandlergehäuse anzugeben, welche sich durch eine einfachere und schnellere Montage auszeichnet.

Die Lösung der Aufgabe erfolgt erfindungsgemäß durch die Merkmale des unabhängigen Anspruchs. Vorteilhafte Ausgestaltungen der Erfindung sind in den Unteransprüchen angegeben.

Eine Lösung der zuvor genannten Aufgabe besteht somit in einer Vorrichtung zur lösbaren Befestigung eines Stromleiters an einem Stromwandlergehäuse, mit dem Stromwandlergehäuse, einem durch das Stromwandlergehäuse hindurchgeführten Halteelement und einem durch das Halteelement hindurchgeführten Befestigungselement, wobei das Befestigungselement und/oder das Halteelement in einem befestigten Zustand des Stromleiters an der Vorrichtung zumindest teilweise an der Oberfläche des Stromleiters anlegbar sind/ist, um den Stromleiter in einer Durchgangsöffnung des Stromwandlergehäuses zu fixieren, das Befestigungselement zum Befestigen bzw. Lösen von dem Stromleiter rotatorisch um seine Längsachse verdrehbar ist, und das Halteelement derart um seine Längsachse rotatorisch verdrehbar ist, dass das Haltelement in einer ersten Rotationsposition entlang seiner Längsachse translatorisch zum Befestigen bzw. Lösen von dem Stromleiter verschiebbar ist und das Halteelement in einer zweiten Rotationsposition entlang seiner Längsachse translatorisch unverschiebbar an dem Stromwandlergehäuse gehalten ist.

Erfindungsgemäß ist also vorgesehen, dass der Stromleiter an dem Stromwandlargehäuse durch eine rotarische Bewegung des Befestigungselements und/oder durch eine translatorische Bewegung des das Halteelements befestigbar ist, also durch zwei prinzipiell unabhängige Bewegungen des Befestigungselements bzw. des Halteelements. Da das Befestigungselement durch das Haltelement hindurchgeführt ist, verbringt eine translatorische Verschiebung des Halteelements auch das Befestigungselement translatorisch. Dabei ist vorgesehen, dass zum einen der Stromleiter durch eine rotatorische Bewegung des Befestigungselements fixierbar ist, also beispielsweise das Befestigungselement als eine Schraube ausgeführt ist, welche in einer dem Halteelement zugeordneten Mutter rotatorisch um seine Längsachse verdrehbar ist. Zum anderen ist vorgesehen, dass das Halteelement als "schnellverschiebbares" Mittel zum Befestigen des Stromleiters derart ausgeführt ist, dass das Halteelement in einer ersten Rotationsposition hin zum Stromleiter bzw. weg vom Stromleiter frei verschiebbar ist und in einer zweiten Rotationsposition, beispielsweise 90° verdreht zu der ersten Rotationsposition, translatorisch unverschiebbar ist, also in der zweiten Rotationsposition an dem Stromwandlergehäuse hinsichtlich einer translatorischen Bewegung entlang seiner Längsachse fixiert ist. Somit ist also möglich, gemäß der erfindungsgemäßen Vorrichtung das Halteelement zunächst in der ersten Rotationsposition translatorisch entlang seiner Längsachse hin zum Stromleiter zu bewegen, dann das Halteelement in seine Rotationsposition rotatorisch zu verdrehen, so dass dann durch eine rotatorische Bewegung des Befestigungselements der Stromleiter fixierbar ist. Eine derartige Vorgehensweise bzw. die erfindungsgemäße Vorrichtung hat den enormen Vorteil, dass durch eine derartige "Schnellbefestigung" der translatorischen Bewegung in Verbindung mit einer "Feinjustierung" der rotatorischen Bewegung der Stromleiter besonders präzise und sicher an dem Stromwandlergehäuse befestigbar ist.

Das Befestigungselement und/oder das Halteelement sind vorzugsweise jeweils in Form eines länglichen stiftartigen Elements ausgebildet, welches zur Befestigung des Stromleiters in Richtung entlang seiner Längsachse bewegbar ist. Dabei kann zur Befestigung des Stromleiters das Befestigungselement und/oder das Halteelement in Richtung des Stromleiters bewegt werden und zum Lösen des Stromleiters das Befestigungselement bzw. das Halteelement von dem Stromleiter weg bewegt werden, wobei das Befestigungselement und das Halteelement vorzugsweise derart zum Stromleiter angeordnet sind bzw. zum Stromleiter geführt sind, dass die Längsachse des Befestigungselements bzw. des Haltelements im Wesentlichen quer zur Längsachse des Stromleiters angeordnet ist. In dem befestigten Zustand, bei welchem der Stromleiter an dem Stromwandlergehäuse fixiert ist, liegen das Befestigungselement und/oder das Halteelement vorzugsweise mit seiner jeweiligen Querschnittsfläche auf der Oberfläche des Stromleiters auf. Zur Befestigung des Stromleiters an dem Stromwandlergehäuse sind, wie vorab ausgeführt, zum einen das Befestigungselement rotatorisch um seine Längsachse verdrehbar und zum anderen das Halteelement translatorisch entlang seiner Längsachse verschiebbar, wobei vorzugsweise eine größere Verschiebung hin zum Stromleiter durch die translatorische Bewegung des Haltelements erfolgt. Ferner kann das Stromwandlergehäuse ein Kunststoffriegel oder einen Flansch aufweisen, welcher beispielsweise an einer Seitenfläche des Stromwandlergehäuses angeordnet ist, wobei in dem Flansch das Halteelement geführt ist.

Durch die erfindungsgemäße Vorrichtung ist es also möglich, sowohl den Aufwand bei der Montage des Stromwandlergehäuses an dem Stromleiter als auch die dabei benötigte Zeit wesentlich zu reduzieren, so dass mit der erfindungsgemäßen Vorrichtung eine Schnellbefestigung eines Stromleiters an einem Stromwandlergehäuse möglich ist. Diese Schnellbefestigung kann dabei vorzugsweise erfolgen, ohne dass ein zusätzliches Werkzeug zur Befestigung notwendig ist. Um eine gleichmäßige Befestigung des Stromleiters an dem Stromwandlergehäuse zu erzielen, sind vorzugsweise an zwei sich gegenüberliegenden Seitenflächen des Stromwandlergehäuses jeweils ein Halteelement mit einem jeweils darin angeordneten Befestigungselement vorgesehen. Grundsätzlich kann das Halteelement beliebig ausgestaltet sein, um in seiner ersten Rotationsposition eine rein translatorische Bewegung entlang seiner Längsachse zu erlauben und in seiner zweiten Rotationsposition eine translatorische Bewegung entlang seiner Längsachse zu unterbinden. Nach einer vorteilhaften Ausgestaltung der Erfindung ist jedoch vorgesehen, dass das Stromwandlergehäuse und das Halteelement in einem zweiten sich in Längsachse des Halteelements erstreckenden Bereich eine jeweils miteinander eingreifende nutfederartige Oberfläche aufweisen, d.h. die Oberfläche ist mit Nut und Feder ausgeführt, und der zweite Bereich zu der zweiten Rotationsposition korrespondiert. Gemäß dieser Ausgestaltung ist also vorgesehen, dass das Stromwandlergehäuse und das Halteelement vorzugsweise jeweils eine nutfederartige Oberfläche derart aufweisen, dass die nutfederartige Oberfläche nur entlang des sich in Längsachse des Halteelements erstreckenden zweiten Bereichs ausgebildet ist. Mit anderen Worten ist gemäß dieser Ausgestaltung also vorgesehen, dass die nutfederartige Oberfläche nur bereichsweise an dem Halteelement und an dem Stromwandlergehäuse ausgebildet ist, beispielsweise vergleichbar zu einem bereichsweise angeordneten "Außengewinde" an dem Halteelement und einem bereichsweise an dem Stromwandlergehäuse angeordneten "Innengewinde" zur Aufnahme des "Außengewindes". Dadurch, dass die jeweilige nutfederartige Oberfläche in dem zweiten Bereich jeweils ineinander eingreift, ist das Halteelement in dieser zweiten Rotationsposition translatorisch unverschiebbar. Um in der ersten Rotationsposition die translatorische Bewegung zu ermöglichen, gibt es viele Möglichkeiten. Nach einer besonders bevorzugten Ausführungsform der Erfindung ist jedoch vorgesehen, dass das Stromwandlergehäuse und/oder das Halteelement in einem ersten sich in Längsachse des Halteelements erstreckenden Bereich eine jeweils im Wesentlichen ebene Oberfläche aufweisen und der erste Bereich zu der ersten Rotationsposition korrespondiert. Dadurch, dass also wenigstens das Stromwandlergehäuse oder das Halteelement in dem ersten Bereich eine im Wesentlichen ebene Oberfläche aufweisen, also beispielsweise eine glatte Oberfläche aufweisen, kann das Halteelement eine translatorische Bewegung relativ zum Stromwandlergehäuse ausführen, wird also nicht gemäß der vorab dargestellten Ausführungsform in seiner translatorischen Bewegung durch eine beispielsweise miteinander in Eingriff befindliche nutfederartige Oberfläche bzw. die dadurch entstehende Reibung gehemmt. Derartige Ausgestaltungen erlauben somit besonders einfache Ausführungsformen, um die translatorische Bewegung des Halteelements in seiner ersten Rotationsposition zuzulassen bzw. in seiner zweiten Rotationsposition zu unterbinden.

Nach einer alternativen bevorzugten Ausführungsform ist vorgesehen, dass das Halteelement in einem ersten sich in Längsachse des Halteelements erstreckenden Bereich eine nutfederartige Oberfläche aufweist, der Außendurchmesser des Halteelements entlang seiner Längsachse in dem ersten Bereich kleiner ist als in dem zweiten Bereich und der erste Bereich zu der ersten Rotationsposition korrespondiert. Bei dieser Ausgestaltung ist also vorgesehen, dass das Halteelement sowohl in dem ersten Bereich als auch in dem zweiten Bereich eine nutfederartige Oberfläche aufweist, jedoch die Federn in dem zweiten Bereich einen größeren Durchmesser als in dem ersten Bereich aufweisen, so dass dadurch das Halteelement in der ersten Rotationsposition translatorisch verschiebbar ist und in der zweiten Rotationsposition translatorisch unverschiebbar ist. Vorzugsweise weist das Stromwandlergehäuse in einem zu dem ersten Bereich in der ersten Rotationsposition korrespondierenden Bereich eine im Wesentlichen ebene Oberfläche auf, so dass die nutfederartige Oberfläche des ersten Bereichs in dem in der ersten Rotationsposition korrespondierenden Bereich des Stromwandlergehäuses nicht eingreifen kann. In diesem Zusammenhang ist ferner bevorzugt, dass die nutartige Oberfläche des Halteelements als Öffnung ausgeführt ist. Dies hat den Vorteil, dass das Halteelement mit einem geringeren Gewicht fertigbar ist.

Grundsätzlich können das Befestigungselement und/oder das Halteelement als beliebige dem Fachmann aus dem Stand der Technik bekannte Mittel zum Befestigen des Stromleiters ausgeführt sein. Nach einer besonders bevorzugten Ausführungsform der Erfindung ist jedoch vorgesehen, dass das Befestigungselement als Schraube ausgeführt ist, das Halteelement ein Gewinde aufweist und die Schraube zum Befestigen bzw. Lösen von dem Stromleiter rotatorisch in dem Gewinde verdrehbar ist. Somit lässt sich das Befestigungselement besonders einfach ausführen und in einfacher Weise an dem Halteelement rotatorisch verdrehbar fixieren. Das Gewinde ist vorzugsweise als Mutter, als Vierkantmutter, als Sechskantmutter und/oder als Einpressmutter ausgeführt.

Nach einer weiteren bevorzugten Ausführungsform der Erfindung weist die Vorrichtung ein an dem Stromwandlergehäuse angeordnetes Aufnahmeelement auf, wobei das Halteelement durch das Aufnahmeelement hindurchgeführt ist und das Aufnahmeelement lösbar an dem Stromwandlergehäuse befestigt ist. Das bedeutet, dass das Aufnahmeelement mit dem durch das Aufnahmeelement hindurchgeführten Halteelement und dem darin angeordneten Befestigungselement an dem Stromwandlergehäuse beispielsweise auch nachträglich, also im Sinne einer Nachrüstung für ein bereits existierendes Stromwandlergehäuse, befestigbar ist, so dass sich eine besonders universelle Verwendung mit vielfältigen Einsatzmöglichkeiten ergibt. Dabei weist vorzugsweise das Aufnahmeelement und/oder das Stromwandlergehäuse Mittel zum lösbaren Anbringen des Aufnahmeelements an dem Stromwandlergehäuse auf, wie beispielsweise Rastmittel, welche eine besonders einfache Anbringung bzw. Entfernung ermöglichen.

Auch was die Ausgestaltung des Haltelements angeht, sind vielfältige Möglichkeiten denkbar. Nach einer bevorzugten Ausführungsform der Erfindung ist jedoch vorgesehen, dass das Halteelement einen im Wesentlichen kreisartigen Querschnitt aufweist und der erste Bereich und der zweite Bereich sich jeweils über einen Umfangsbogen von 90° oder 180° erstrecken. Demzufolge ist also auch bevorzugt, dass die erste Rotationsposition 90° bzw. 180° von der zweiten Rotationsposition beabstandet angeordnet ist. Ebenfalls sind weitere Erstreckungen des ersten bzw. zweiten Bereichs möglich, wie zum Beispiel 45° oder 22,5°, also vorzugsweise jeweils miteinander kombinierbare Teilbereiche. Das bedeutet also, dass gemäß diesem bevorzugten Ausführungsbeispiel der Erfindung das Halteelement entlang seiner sich in Längsrichtung erstreckenden Oberfläche beispielsweise jeweils zwei gegenüber angeordnete Bereiche mit einem Umfangsbogen von je 90° aufweisen, die die nutfederartige Oberfläche aufweisen und zwischen den nutfederartigen Oberflächen jeweils zwei Bereiche mit einer ebenen Oberfläche aufweisen. Dementsprechend wäre gemäß diesem Beispiel auch die zu der Oberfläche des Halteelements korrespondierende Oberfläche des Stromwandlergehäuses auszuführen, also jeweils zwei Bereiche mit einem Umfangsbogen von 90° mit einer nutfenderartigen Oberfläche auszugestalten, die jeweils von zwei ebenen Bereichen, ebenfalls mit einem Umfangsbogen von 90°, unterbrochen sind.

Nach einer weiteren bevorzugten Ausführungsform der Erfindung weist das Halteelement und/oder das Befestigungselement jeweils einen Kopf mit einer rändelartigen Grifffläche auf, d.h. die Grifffläche ist als Rändelfläche ausgeführt. Bevorzugt ist die Grifffläche als nutfederartige Außenumfangsfläche ausgeführt. Vorzugsweise sind die Nuten bzw. Federn parallel zur Längsachse des Halteelements bzw. des Befestigungselements ausgerichtet. Durch einen derartigen Kopf lassen sich das Halteelement bzw. das Befestigungselement sehr einfach translatorisch bzw. rotatorisch bewegen.

Die Lösung der Aufgabe erfolgt ferner durch ein Verfahren zum Befestigen eines Stromleiters an einem Stromwandlergehäuse mit einem Halteelement und/oder mit einem Befestigungselement, mit dem Stromwandlergehäuse, dem durch das Stromwandlergehäuse hindurchgeführten Halteelement und dem durch das Halteelement hindurchgeführten Befestigungselement, wobei das Befestigungselement und/oder das Halteelement in einem befestigten Zustand des Stromleiters zumindest teilweise an der Oberfläche des Stromleiters anliegen, um den Stromleiter in einer Durchgangsöffnung des Stromwandlergehäuses zu fixieren, und das Halteelement um seine Längsachse rotatorisch von einer ersten Rotationsposition in eine zweite Rotationsposition verdrehbar ist, mit den Schritten: Verschieben des Halteelements in der ersten Rotationsposition translatorisch entlang seiner Längsachse hin zum Stromleiter, Verdrehen des Halteelements in die zweite Rotationsposition, wobei das Halteelement in der zweiten Rotationsposition entlang seiner Längsachse translatorisch unverschiebbar an dem Stromwandlergehäuse gehalten ist, und Verdrehen des Befestigungselements rotatorisch um seine Längsachse hin zum Stromleiter.

Durch ein derartiges erfindungsgemäßes Verfahren kann ein Stromleiter besonders einfach und schnell an dem Stromwandlergehäuse fixiert werden, wobei im Sinne einer "Schnellbefestigung" zunächst das Halteelement bevorzugt bis zum Auftreffen auf den Stromleiter rein translatorisch geführt ist und erst zur endgültigen Fixierung auf der Oberfläche des Stromleiters eine rotatorische Bewegung zur "Feinjustierung" ausübt. Hierdurch kann die Montagezeit und der Montageaufwand deutlich reduziert werden.

Weitere Vorteile und Ausgestaltungen zu dem erfindungsgemäßen Verfahren ergeben sich für den Fachmann in Analogie zu dem Vorabgesagten zu der erfindungsgemäßen Vorrichtung.

Nachfolgend wird die Erfindung unter Bezugnahme auf die Zeichnung anhand bevorzugter Ausführungsbeispiele näher erläutert.

In der Zeichnung zeigen:
- Fig. 1: eine Vorrichtung zur lösbaren Befestigung eines Stromleiters an einem Stromwandlergehäuse gemäß einem bevorzugten Ausführungsbeispiel der Erfindung in einer perspektivischen Ansicht,
- Fig. 2: ein Aufnahmeelement mit einem Halteelement und einem Befestigungselement gemäß dem bevorzugten Ausführungsbeispiel der Erfindung in einer perspektivischen Explosionsansicht,
- Fig. 3: das Aufnahmeelement gemäß der vorherigen Figur in einer perspektivischen Teil-Schnittansicht, und
- Fig. 4: das Aufnahmeelement gemäß dem bevorzugten Ausführungsbeispiel der Erfindung in einer Draufsicht.

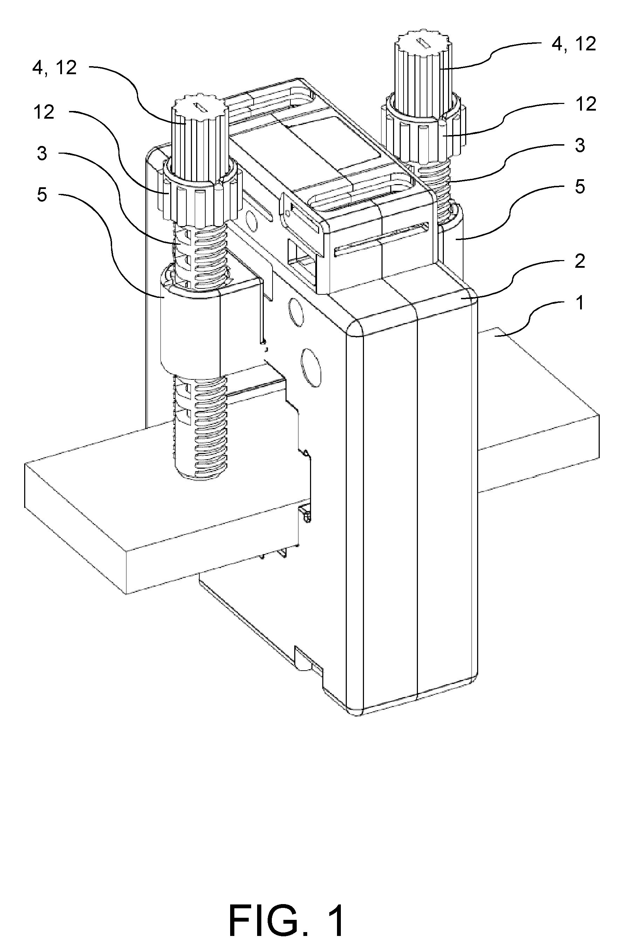

Aus Fig. 1 ist eine Vorrichtung zur lösbaren Befestigung eines Stromleiters 1 an einem Stromwandlergehäuse 2 mit einem Halteelement 3 und/oder mit einem Befestigungselement 4 ersichtlich. Das Halteelement 3 ist dabei durch ein an dem Stromwandlergehäuse 2 lösbar befestigbares Aufnahmeelement 5 hindurchgeführt. Das Aufnahmeelement 5 ist mittels eines Verrastungsmittels, nicht gezeigt, mit dem Stromwandlergehäuse 2 verrastbar. Alternativ kann das Aufnahmeelement 5 auch im befestigten Zustand des Stromleiters 1 an dem Stromwandlergehäuse 2 von dem Halteelement 3 bzw. dem Befestigungselement 4 derart gegen das Stromwandlergehäuse 2 gedrückt werden, dass kein weiteres Befestigungsmittel zum Befestigen des Aufnahmeelements 5 an dem Stromwandlergehäuse 2 notwendig ist.

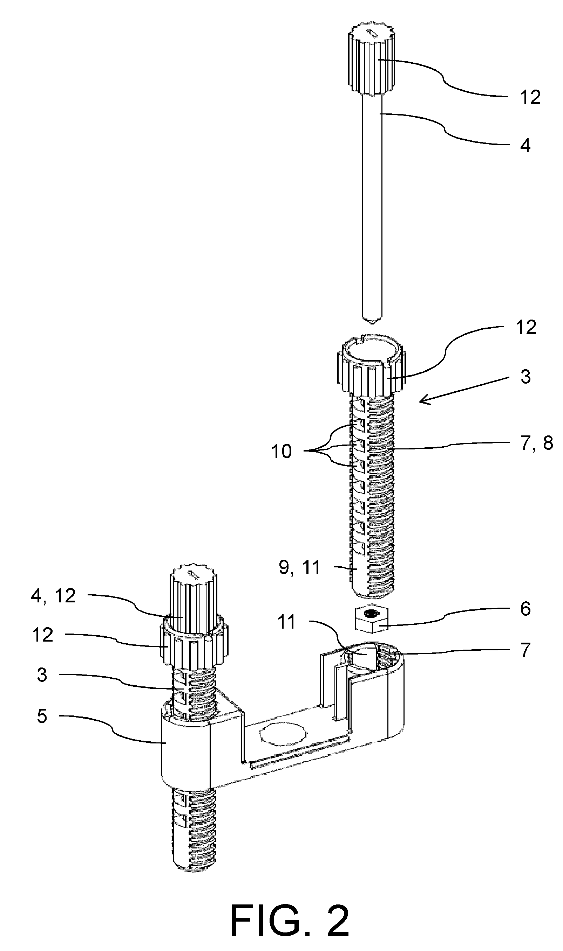

Wie beispielsweise aus Fig. 2 ersichtlich, ist das als Schraube ausgeführte Befestigungselement 4 durch das Halteelement 3 derart hindurchgeführt, dass die Schraube 4 in einem als Mutter ausgeführten Gewinde 6 rotatorisch um seine Längsachse zum Befestigen des Stromleiters 1 an dem Stromwandlergehäuse 2 verdrehbar ist.

Das Halteelement 3 ist in dem Aufnahmeelement 5 derart um seine Längsachse rotatorisch verdrehbar, dass das Halteelement 3 in einer ersten Rotationsposition entlang seiner Längsachse translatorisch zum Befestigen bzw. Lösen von dem Stromleiter 1 verschiebbar ist und das Halteelement 3 in einer zweiten Rotationsposition entlang seiner Längsachse translatorisch unverschiebbar ist. Dazu weisen das Aufnahmeelement 5 und das Halteelement 3 jeweils eine nutfederartige Oberfläche 7 auf, welche in der zweiten Rotationsposition derart miteinander eingreifen, dass das Halteelement 3 gegenüber dem Aufnahmeelement 5 translatorisch unverschiebbar ist.

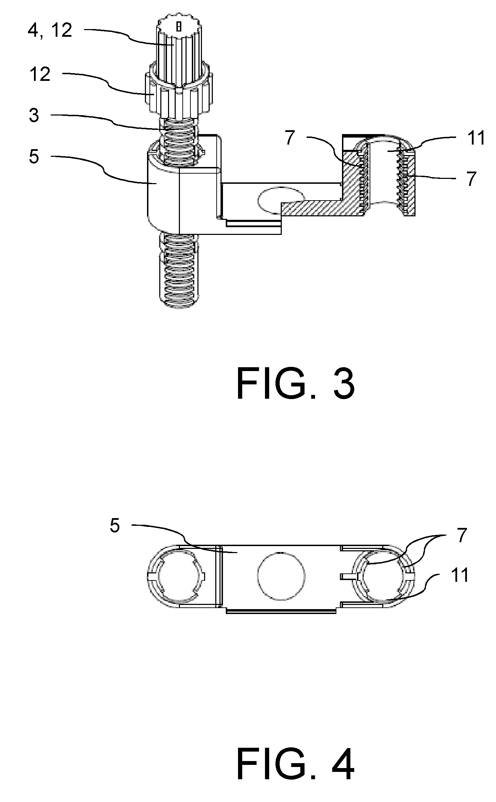

Wie aus Fig. 2 bis 4 ersichtlich, weist dazu das Halteelement 3 entlang seiner in Längsachse sich erstreckenden Außenoberfläche einen zweiten Bereich 8 auf, welcher jeweils, wie aus Fig. 2 ersichtlich, ein Viertel des Außenumfangs der Oberfläche auf der "Vorderseite" und "Rückseite" des Halteelements 3 bedeckt. Zwischen den nutfederartig ausgestalteten Oberflächen 7 des zweiten Bereichs 8 befindet sich ein erster Bereich 9, welcher eine ebenfalls nutfederartige Oberfläche 7 aufweist, wobei in diesem ersten Bereich 9 die Nuten als Öffnungen 10 ausgeführt sind.

Sofern nun dieser erste Bereich 9 des Halteelements 3 in dem Aufnahmeelement 5 in der ersten Rotationsposition korrespondierend zu einer ebenen Oberfläche 11 des Aufnahmeelements 5 ausgerichtet ist, kann das Halteelement 3 in dieser ersten Rotationsposition entlang seiner Längsachse translatorisch in dem Aufnahmeelement 5 zum Befestigen bzw. Lösen von dem Stromleiter 1 verschoben werden. Zur einfachen Betätigung weisen das Halteelement 3 als auch das Befestigungselement 4 jeweils eine Kopf 12, somit beispielsweise die Schraube einen umspritzten Kopf 12, auf.

Zum Befestigen des Stromleiters 1 an dem Stromwandlergehäuse 2 erfolgt bevorzugt folgender Ablauf: Das Halteelement 3 wird in dem Aufnahmeelement 5 in der ersten Rotationsposition, indem die ebenen Oberflächen 11 des Halteelements 3 bzw. des Aufnahmeelements 5 zueinander korrespondieren, in Richtung des Stromleiters 1 translatorisch verschoben. Sobald das Halteelement 3 den Stromleiter 1 berührt oder möglichst nah zu der Oberfläche des Stromleiters 1 ausgerichtet ist, wird das Halteelement 3 in seine zweite Rotationsposition rotatorisch gegenüber dem Aufnahmeelement 5 verdreht. In dieser zweiten Rotationsposition greifen die bereichsweise angeordneten nutfederartigen Oberflächen 7 des Halteelements 3 und des Aufnahmeelements 5 derart ineinander, dass das Halteelement 3 entlang seiner Längsachse translatorisch unverschiebbar ist. Zur endgültigen Fixierung erfolgt nun eine rotatorische Bewegung des Befestigungselements 4 also des als Schraube ausgeführten Befestigungselements 4 in dem Gewinde 6. Dadurch kann die Montagezeit und der Montageaufwand erheblich gegenüber aus dem Stand der Technik bekannten Vorrichtungen reduziert werden.

**Bezugszeichenliste**

| | |
|---|---|
| Stromleiter | 1 |
| Stromwandlergehäuse | 2 |
| Halteelement | 3 |
| Befestigungselement | 4 |
| Aufnahmeelement | 5 |
| Gewinde | 6 |
| Nutfederartige Oberfläche | 7 |
| Zweiter Bereich | 8 |
| Erster Bereich | 9 |
| Öffnung | 10 |
| Ebene Oberfläche | 11 |
| Kopf | 12 |

## Patentansprüche

1. Vorrichtung zur lösbaren Befestigung eines Stromleiters (1) an einem Stromwandlergehäuse (2), mit dem Stromwandlergehäuse (2), einem durch das Stromwandlergehäuse (2) hindurchgeführten Halteelement (3) und einem durch das Halteelement (3) hindurchgeführten Befestigungselement (4), wobei
das Befestigungselement (4) und/oder das Halteelement (3) in einem befestigten Zustand des Stromleiters (1) an der Vorrichtung zumindest teilweise an der Oberfläche des Stromleiters (1) anlegbar sind/ist, um den Stromleiter (1) in einer Durchgangsöffnung des Stromwandlergehäuses (2) zu fixieren,
das Befestigungselement (4) zum Befestigen bzw. Lösen von dem Stromleiter (1) rotatorisch um seine Längsachse verdrehbar ist, und
das Halteelement (3) derart um seine Längsachse rotatorisch verdrehbar ist, dass das Halteelement (3) in einer ersten Rotationsposition entlang seiner Längsachse translatorisch zum Befestigen bzw. Lösen von dem Stromleiter (1) verschiebbar ist und das Halteelement (3) in einer zweiten Rotationsposition entlang seiner Längsachse translatorisch unverschiebbar an dem Stromwandlergehäuse (2) gehalten ist.

2. Vorrichtung nach dem vorhergehenden Anspruch, wobei das Stromwandlergehäuse (2) und das Halteelement (3) in einem zweiten sich in Längsachse des Halteelements (3) erstreckenden Bereich (8) eine jeweils miteinander eingreifende Oberfläche (7) aufweisen, die mit Nut und Feder ausgeführt sind, und der zweite Bereich (8) zu der zweiten Rotationsposition korrespondiert.

3. Vorrichtung nach einem der vorhergehenden Ansprüche, wobei das Stromwandlergehäuse (2) und/oder das Halteelement (3) in einem ersten sich in Längsachse des Halteelements (3) erstreckenden Bereich (9) eine jeweils im Wesentlichen ebene Oberfläche (11) aufweisen und der erste Bereich (9) zu der ersten Rotationsposition korrespondiert.

4. Vorrichtung nach einem der vorhergehenden Ansprüche, wobei das Halteelement (3) in einem ersten sich in Längsachse des Halteelements (3) erstreckenden Bereich (9) eine Oberfläche (7) aufweist, die mit Nut und Feder ausgeführt ist, der Außendurchmesser des Halteelements (3) entlang seiner Längsachse in dem ersten Bereich (9) kleiner ist als in dem zweiten Bereich (8) und der erste Bereich (9) zu der ersten Rotationsposition korrespondiert.

5. Vorrichtung nach dem vorhergehenden Anspruch 4, wobei die Nut der Oberfläche als Öffnung (10) ausgeführt ist.

6. Vorrichtung nach einem der vorhergehenden Ansprüche, wobei das Befestigungselement (4) als Schraube ausgeführt ist, das Halteelement (3) ein Gewinde (6) aufweist und die Schraube zum Befestigen bzw. Lösen von dem Stromleiter (1) rotatorisch in dem Gewinde (6) verdrehbar ist.

7. Vorrichtung nach einem der vorhergehenden Ansprüche, mit einem an dem Stromwandlergehäuse (2) angeordneten Aufnahmeelement (5), wobei das Halteelement (3) durch das Aufnahmeelement (5) hindurchgeführt ist und das Aufnahmeelement (5) lösbar an dem Stromwandlergehäuse (2) befestigt ist.

8. Vorrichtung nach einem der vorhergehenden Ansprüche, wobei das Halteelement (3) einen im Wesentlichen kreisartigen Querschnitt aufweist, und der erste Bereich (9) und der zweite Bereich (8) sich jeweils über einen Umfangsbogen von 90° oder 180° erstrecken.

9. Vorrichtung nach einem der vorhergehenden Ansprüche, wobei das Halteelement (3) und/oder das Befestigungselement (4) jeweils einen Kopf (12) mit einer als Rändelfläche ausgeführten Grifffläche aufweisen.

10. Verfahren zum Befestigen eines Stromleiters (1) an einem Stromwandlergehäuse (2) mit einem Halteelement (3) und/oder mit einem Befestigungselement (4), mit dem Stromwandlergehäuse (2), dem durch das Stromwandlergehäuse (2) hindurchgeführten Halteelement (3) und dem durch das Halteelement (3) hindurchgeführten Befestigungselement (4), wobei
das Befestigungselement (4) und/oder das Halteelement (3) in einem befestigten Zustand des Stromleiters (1) zumindest teilweise an der Oberfläche des Stromleiter (1) anliegen, um den Stromleiter (1) in einer Durchgangsöffnung des Stromwandlergehäuses (2) zu fixieren, und
das Halteelement (3) um seine Längsachse rotatorisch von einer ersten Rotationsposition in eine zweite Rotationsposition verdrehbar ist, mit den Schritten:
Verschieben des Halteelements (3) in der ersten Rotationsposition translatorisch entlang seiner Längsachse hin zum Stromleiter (1),
Verdrehen des Halteelements (3) in die zweite Rotationsposition, wobei das Halteelement (3) in der zweiten Rotationsposition entlang seiner Längsachse translatorisch unverschiebbar an dem Stromwandlergehäuse (2) gehalten ist, und
Verdrehen des Befestigungselements (4) rotatorisch um seine Längsachse hin zum Stromleiter (1).

## Claims

1. A device for detachably attaching an electrical conductor (1) to a current transformer housing (2), comprising the current transformer housing (2), a holding element (3) which extends through the current transformer housing (2), and an attachment element (4) which extends through the holding element (3),
wherein
the attachment element (4) and/or the holding element (3) can rest at least partially on the surface of the electrical conductor (1) when the electrical conductor (1) is attached to the device in order to fix the electrical conductor (1) in a passage opening of the current transformer housing (2),
the attachment element (4) is rotatable about the longitudinal axis thereof for attachment to or detachment from the electrical conductor (1), and
the holding element (3) can be rotated about the longitudinal axis thereof in such a way that, in a first rotation position, the holding element (3) can be displaced in a translatory manner along the longitudinal axis thereof for attachment to or detachment from the electrical conductor (1), and, in a second rotation position, the holding element (3) is held on the current transformer housing (2) so as to be non-displaceable in a translatory manner along the longitudinal axis thereof.

2. The device according to any one of the preceding claims, wherein, in a second region (8) extending in the longitudinal axis of the holding element (3), the current transformer housing (2) and the holding element (3) each have a mutually engaging surface (7) having a groove and a spring, and the second region (8) corresponds to the second rotation position.

3. The device according to any one of the preceding claims, wherein, in a first region (9) extending in the longitudinal axis of the holding element (3), the current transformer housing (2) and/or the holding element (3) each have a substantially planar surface (11) and the first region (9) corresponds to the first rotation position.

4. The device according to any one of the preceding claims, wherein, in a first region (9) extending in the longitudinal axis of the holding element (3), the holding element (3) has a surface (7), which is designed with a groove and a spring, the outer diameter of the holding element (3) along the longitudinal axis thereof is smaller in the first region (9) than in the second region (8) and the first region (9) corresponds to the first rotation position.

5. The device according to the preceding claim 4, wherein the groove in the surface is designed as an opening (10).

6. The device according to any one of the preceding claims, wherein the attachment element (4) is designed as a screw, the holding element (3) comprises a thread (6), and the screw can be rotated in the thread (S) for attachment to or detachment from the electrical conductor (1).

7. The device according to any one of the preceding claims, comprising a receiving element (5) disposed on the current transformer housing (2), wherein the holding element (3) extends through the receiving element (5) and the receiving element (5) is detachably attached to the current transformer housing (2).

8. The device according to any one of the preceding claims, wherein the holding element (3) has a substantially circular cross-section, and the first region (9) and the second region (8) each extend over a circumferential arc of 90° or 180°.

9. The device according to any one of the preceding claims, wherein the holding element (3) and/or the attachment element (4) each have a head (12) having a gripping surface designed as a knurled surface.

10. A method for attaching an electrical conductor (1) to a current transformer housing (2) with a holding element (3) and/or with an attachment element (4), with the current transformer housing (2), the holding element (3) which extends through the current transformer housing (2), and the attachment element (4) which extends through the holding element (3), wherein
the attachment element (4) and/or the holding element (3) rest at least partially on the surface of the electrical conductor (1) when the electrical conductor (1) is attached in order to fix the electrical conductor (1) in a passage opening of the current transformer housing (2), and
the holding element (3) is rotatable, about the longitudinal axis thereof, out of a first rotation position and into a second rotation position, having the steps of: in the first rotation position, displacing the holding element (3) in a translatory manner along the longitudinal axis thereof toward the electrical conductor (1),
rotating the holding element (3) into the second rotation position, wherein, in the second rotation position, the holding element (3) is held on the current transformer housing (2) so as to be non-displaceable in a translatory manner along the longitudinal axis thereof, and
rotating the attachment element (4) about the longitudinal axis thereof toward the electrical conductor (1).

## Revendications

1. Dispositif de fixation amovible d'un conducteur électrique (1) sur un boîtier de convertisseur de courant (2), avec le boîtier de convertisseur de courant (2), un élément de retenue (3) passant à travers le boîtier de convertisseur de courant (2) et un élément de fixation (4) passant à travers l'élément de retenue (3), dans lequel
l'élément de fixation (4) et/ou l'élément de retenue (3), dans un état de fixation du conducteur électrique (1) sur le dispositif, peut / peuvent être appliqué/s au moins partiellement à la surface du conducteur électrique (1), afin de fixer le conducteur électrique (1) au niveau d'un orifice de passage du boîtier de convertisseur de courant (2),
l'élément de fixation (4) peut être mis en rotation autour de son axe longitudinal pour la fixation, respectivement le détachement, du conducteur électrique (1), et
l'élément de retenue (3) pouvant être mis en rotation autour de son axe longitudinal de telle manière que l'élément de retenue (3) peut être coulissé par translation le long de son axe longitudinal dans une première position de rotation pour la fixation, respectivement, le détachement, du conducteur électrique (1), et l'élément de retenue (3) est maintenu en ne pouvant pas coulisser par translation le long de son axe longitudinal sur le boîtier de convertisseur de courant (2) dans une deuxième position de rotation.

2. Dispositif selon la revendication précédente, dans lequel le boîtier de convertisseur de courant (2) et l'élément de retenue (3) présentent une surface (7) les mettant en prise respectivement l'un avec l'autre dans une deuxième région (8) s'étendant dans l'axe longitudinal de l'élément de retenue (3), qui sont conçus avec une rainure et un ressort, et la deuxième région (8) correspond à la deuxième position de rotation.

3. Dispositif selon l'une des revendications précédentes, dans lequel le boîtier de convertisseur de courant (2) et/ou l'élément de retenue (3) présentent respectivement une surface (11) essentiellement plane dans une première région (9) s'étendant dans l'axe longitudinal de l'élément de retenue (3) et la première région (9) correspond à la première position de rotation.

4. Dispositif selon l'une des revendications précédentes, dans lequel l'élément de retenue (3) présente une surface (7) dans une première région (9) s'étendant dans l'axe longitudinal de l'élément de retenue (3), qui est conçue avec une rainure et un ressort, le diamètre extérieur de l'élément de retenue (3) est plus petit le long de son axe longitudinal dans la première région (9) que dans la deuxième région (8), et la première région (9) correspond à la première position de rotation.

5. Dispositif selon la revendication 4 précédente, dans lequel la rainure de la surface est conçue sous la forme d'un orifice (10).

6. Dispositif selon l'une des revendications précédentes, dans lequel l'élément de fixation (4) est conçu sous la forme d'une vis, l'élément de retenue (3) présente un filetage (6) et la vis pour la fixation, respectivement, le détachement, du conducteur électrique (1) peut être mise en rotation dans le filetage (6).

7. Dispositif selon l'une des revendications précédentes, avec un élément de logement (5) disposé sur le boîtier de convertisseur de courant (2), dans lequel l'élément de retenue (3) passe à travers l'élément de logement (5) et l'élément de logement (5) est fixé de manière amovible sur le boitier de convertisseur de courant (2).

8. Dispositif selon l'une des revendications précédentes, dans lequel l'élément de retenue (3) présente une section transversale essentiellement de type circulaire, et la première région (9) et la deuxième région (8) s'étendent chacune sur un arc circonférentiel de 90 ° ou de 180 °.

9. Dispositif selon l'une des revendications précédentes, dans lequel l'élément de retenue (3) et/ou l'élément de fixation (4) présentent chaque fois une tête (12) avec une surface de saisie conçue sous la forme d'une surface moletée.

10. Procédé de fixation d'un conducteur électrique (1) sur un boîtier de convertisseur de courant (2) avec un élément de retenue (3) et/ou avec un élément de fixation (4), avec le boitier de convertisseur de courant (2), l'élément de retenue (3) passant à travers le boitier de convertisseur de courant (2) et l'élément de fixation (4) passant à travers l'élément de retenue (3),
dans lequel
l'élément de fixation (4) et/ou l'élément de retenue (3), dans un état de fixation du conducteur électrique (1) sur le dispositif, sont appliqués au moins partiellement contre la surface du conducteur électrique (1), afin de fixer le conducteur électrique (1) au niveau d'un orifice de passage du boîtier de convertisseur de courant (2), et
l'élément de retenue (3) peut être mis en rotation autour de son axe longitudinal à partir d'une première position de rotation vers une deuxième position de rotation, avec les étapes :
de coulissement par translation de l'élément de retenue (3) le long de son axe longitudinal vers le conducteur électrique (1) dans la première position de rotation,
de rotation de l'élément de retenue (3) dans la deuxième position de rotation, où l'élément de retenue (3) dans la deuxième position de rotation, est maintenu en ne pouvant pas coulisser par translation le long de son axe longitudinal sur le boitier de convertisseur de courant (2), et
de rotation de l'élément de fixation (4) autour de son axe longitudinal vers le conducteur électrique (1).
